# EUROPEAN PATENT APPLICATION

(11) **EP 0 782 191 A2**
(43) Date of publication of application: **02.07.1997**
(21) Application number: 96308958.6
(22) Date of filing: 10.12.1996
(51) Int. Cl.: H01L 25/065

(54) **Multi-level stacked integrated-circuit-chip assembly**

(30) Priority: 28.12.1995 US 580220
(71) Applicant: Lucent Technologies Inc., Murray Hill, New Jersey 07974-0636 (US)
(72) Inventor: Degani, Yinon, Highland Park, New Jersey 08904 (US); Han, Byung Joon, Seoul (KR); Dudderar, Thomas Dixon, Chatham, New Jersey 07928 (US)
(74) Representative: Johnston, Kenneth Graham

(57) **Abstract**

A multi-level stack of integrated circuit has alternating chips and flip-chips, together with wirebonds that interconnect wiring pads (I/O pads) of the chips located on differing levels of the stack. In addition, solder bumps located between chips and flip-chips located in vertically adjacent levels interconnect the wiring pads of these chips with the wiring pads of these flip-chips.

## Description

### Field of the Invention

This invention relates to integrated circuit assemblies and more particularly to those assemblies comprising a multiplicity of electrically interconnected semiconductor integrated circuit chips.

### Background of the Invention

As known in the art, a semiconductor integrated circuit chip (hereinafter, simply "chip"), typically a semiconductive silicon chip, has a pair of opposing parallel major surfaces. All of the circuit elements of such a chip including transistors and metallization lines between the transistors, are integrated on only one of the major surfaces of the chip. Thereby, physical and topological constraints are imposed on chip-to-chip interconnections.

In prior art, workers in the art have attempted to interconnect a multiplicity of chips by means of various arrangements and assemblies. For example, European Patent Application 0,304,263 published on February 22,1989 teaches a three level assembly. The assembly includes, among other things, a daughter chip, located on, and thereby defining, a top level of the assembly. The daughter chip is supported by an intermediate chip, located on, and there by defining, an intermediate level of the assembly. The daughter chip is oriented as a flip-chip--i.e., with it's integrated circuit(s) and wiring pads located on it's bottom major surface. The intermediate chip is supported by a mother chip, located on, and thereby defining, a bottom level assembly. Solder bumps electrically connect wiring pads ("I/O pads" or "Input-Output pads") located on the bottom surface of the daughter chip with wiring pads located on the top surface of the intermediate chip. Also, wirebonds electrically connect wiring pads located on the top surface of the mother chip.

Disadvantages with this assembly include the fact that electrical signals coming from the daughter chip and intended as input for the mother chip must first be routed through the intermediate chip--which unduly delays the signal transmission, as well as wastes valuable space on the intermediate chip. In addition. this assembly requires that either the intermediate chip be wider (in at least some lateral regions) than the daughter chip --which can impose undesirable practical constraints such as unavailability or which can be inconvenient or that the intermediate chip have at two separate smaller parts--which also can impose undesirable constraints or can be inconvenient.

In addition to integrated chips, workers have employed wiring substrates -- such as printed circuit boards, printed wiring boards, "mother" boards, metallic lead frames, ceramic wiring substrates, and silicon wiring substrates -- to supply mechanical support for the assembly of chips and to supply electrically conductive wiring connected to the chips for external electrical access to the chips via the wiring substrate. These wiring substrates can form part of the assembly. However. in prior art assemblies, they do not obviate the disadvantages of the kinds mentioned above.

Therefore it would be desirable to have an assembly of integrated circuit chips that mitigates on or more of the foregoing disadvantages.

### Summary of the Invention

This invention mitigates one or more of the foregoing disadvantages by providing an assembly comprising a multi-level stacked chip assembly. Alternating levels of the stack comprise chips and flip-chips respectively. For example, odd-numbered levels (counting from the bottom of the stack ) comprise chips; even-numbered levels comprise flip-chips. Each of the chips and flip-chips has at least one wiring pad located on a major surface thereof. At least one wirebond connects a wiring pad located on a top major surface of a chip located on one level with a wiring pad of a chip located on another level. The chips having the wiring pads connected by the wirebond(s) are vertically separated by at least one level comprising at least one flip-chip.

Instead of a chip, a wiring substrate can constitute a level.

Advantageously, the bottom surface(s) of chip(s) are adhesively bonded by an insulating adhesive to the top surface(s) of flip-chip(s) located on the respective next lower level(s) relative to the chip(s). Advantageously further, solder bumps electrically connect the wiring pads located on the bottom surfaces of flip-chip(s) to wiring pads of chip(s) located on the top surfaces on the next lower level relative to the flip-chip(s).

In a specific embodiment, a multi-level stacked integrated-circuit-chip assembly comprises:
(A) wiring substrate or first integrated circuit chip;
(a) second and third integrated circuit chips, the third chip located overlying the second chip, and the second chip overlying the wiring substrate or the first integrated circuit chip;
(b) wirebond directing electrically connecting a first wiring pad located on the top surface of the wiring pad located on the top surface of the wiring substrate or the first chip with a third wiring pad located on the top surface of the third chip.

As used herein, the term "directly electrically connecting" refers to the situation in which the wirebond does not electrically contact any wiring pad located on any level intervening between the (two) pads that the wirebond connects.

Advantageously, the bottom surface of the second chip has at least one wiring pad that is electrically connected to a wiring pad located on the top surface of the first chip or the wiring substrate by means of a solder bump. Advantageously further, and adhesive layer bonds the bottom surface of the third chip to the top surface of the second chip.

The major surfaces of the second and third chips (where their respective integrated circuits are located) thus can have identical lateral dimensions. Such equality in lateral dimensions is advantageous not only in cases where only available second and third chips have identical lateral dimensions but also in cases where minimization of lateral area("minimum footprint") is desired. In addition, if desired, these chips can have the same thickness. Moreover, more than a single third chip can be located overlying the second chip. Also, the assembly can have more than three levels formed by (1) the wiring substrate or the first chip, (2) the second chip, and (3) the third chip, each level comprising one or more chips or wiring substrates.

### Brief Description of the Drawing

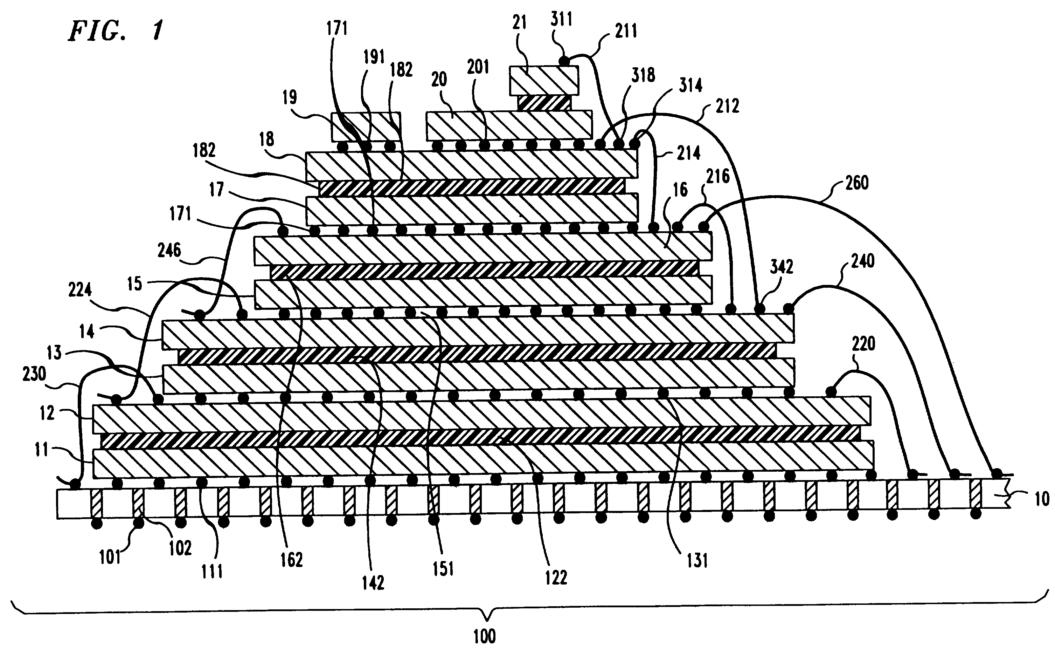

FIG. 1 shows an elevation view, partly in cross-section, of a multi-level stacked integrated circuit-chip assembly according to a specific embodiment of the invention.

Only for the sake of clarity, the drawing is not to any scale.

### Detailed Description

Turning to the drawing, FIG. 1 shows an illustrative multi-level stacked integrated-circuit-chip assembly 100. This assembly 100 comprises of a motherboard 10 that supports chips 11, 12, 13, 14, 15, 16. 17, 18, 19, 20, and 21. The motherboard 10 has an array of electrical contacts 101 for external electrical access. Via holes (apertures) in the mother board 10 are filled with metallic plugs 102 or are plated with copper (not shown) or are both filled with the plugs 102 and are plated with copper, in order to provide electrical access from the top surface to the bottom surface of the mother board 10.

The chips 19, 20, 17, 15, 13, and 11 are thus flip-chips because their bottom major surfaces, rather than their top major surfaces, contain the respective integrated circuitry of these respective chips. These chips 19,20, 17, 15, 13, and 11 thus have wiring (not shown for the purpose of clarity), that are located on their respective bottom surfaces. The other chips 21,18, 16, 14, and 12 thus have wiring (not show for the purpose of clarity), as well as wiring pads (not all of which are shown, only for the purpose of clarity), that are located on their respective top major surfaces. Only for the sake of clarity, not all of the wiring pads are labeled with reference numerals.

Chips 19 and 20 are located on the same (next-to-top) level, intervening the levels on which the chips 18 and 21 are located, only for illustrative purposes. The respective bottom surfaces of the chips 21, 18, 16, 14 and 12 are adhesively bonded by respective adhesive bonding layers 212, 182, 162, 142, and 122 to the top surfaces of the chips 20, 17, 15, 13, and 11 respectively. Typically the adhesive bonding layers 212, 182, 162, 142 and 122 are electrically insulating and can have a more complicated structure to relieve stress, as is disclosed in US Patent No. 5,473,512 and in the pending application "Electronic Device Package Enclosed by a Pliant Medium Laterally Confined by a Plastic Rim Member" filed on December 4, 1995 (T. D. Duddear 16-6-6-21)

An array of solder bumps 191 and an array of solder bumps 201 directly electrically connect at least some of the wiring pads located on the bottom surfaces of the chip 19 and the chip 20 respectively, with at least some of the wiring pads located on the top surface of the chip 18. Similarly, an array of solder bumps 171 electrically connects at least some of the wiring pads located on the bottom surface of the chip 17 with at least some of the wiring pads located on the top surface of the chip 16. Likewise, an array of solder bumps 151, solder bumps 131, and solder bumps 111 electrically connect wiring pads located on the top surface of the chip 14, the chip 12 and the mother board 10, respectively.

Wirebond 211 electrically connects a wiring pad 311 located on the top surface of the chip 21 with a wiring pad 318 located on the top surface of the chip 18, while wirebond 214 electrically connects another wiring pad 314 located on the top surface of chip 18 with a wiring pad located on the top surface of the chip 16. Wirebond 216 electrically connects another wiring pad located on the top surface of the chip 16 with a wiring pad located on the top surface of the chip 14. Wirebond 212 electrically connects another wiring pad located on the tip surface of the chip 18 with another wiring pad 342 located on the tip surface of the chip 14. Wirebond 260 electrically connects another wiring pad located on the top surface of the chip 16 located on the tip surface of the motherboard 10.

Wirebond 220 and 230 electrically connect separate wiring pads located on the top surface of the chip 12 with separate wiring pads located on the top surface of the motherboard 10. Wirebond 246 electrically connects yet another wiring pad located on the top surface of the chip 16 with yet another wiring pad located on the top surface of the chip 14. Wirebond 224 electrically connects a wiring pad located on the top surface of the chip 14 with a wiring pad located on the top surface of the chip 12.

Every wirebond thus skips at least one level, and generally can skip any odd number of levels.

Although the invention has been described in detail in terms of a specific embodiment, various modifications can be made without departing from the scope of the invention. For example, the motherboard 100 can be replaced by wiring substrate other than a motherboard or by an integrated circuit chip. The number of levels can be reduced to as few as three levels, with at least one wirebond electrically connecting a wiring pad located on the top surface of the top level (i.e., the top chip) with a wiring pad located on the top surface of the bottom level (i.e., the motherboard, or other wiring substrate, or another chip) advantageously maintain an array of solder bumps between the bottom surface of the (flip-chip) intermediate level and the top surface bottom level.

Also, the motherboard 10 can be another chip (not shown), numbered say 110 for convenience of discussion, having at least one portion thereof that's wider than an overlying portion of the chip 11. In such a case, advantageously a wiring substrate have wider lateral dimensions than those of the chip 110, such as a metallic lead frame (not shown), underlies the chip 110; and advantageously the bottom surface of this chip 110 has solder bumps that are soldered to the top surface of the wiring substrate. Also, in such a case, advantageously the top surface of the chip 110 has at least one wirebond that connects a wiring pad located on the top surface of this chip 110 with a wiring pad located on the top surface of the wiring substrate. Also, in such a case, advantageously at least one wirebond connects a wiring pad located on the top surface of the chip 12 directly with a wiring pad located on the top surface of the wiring substrate located beneath the chip 110.

## Claims

1. A multi-level stacked integrated-circuit-chip assembly comprises:
(a) a first device comprising a wiring substrate or a first integrated circuit chip, a top major surface of the first device having at least a first wiring pad;
(b) second and third devices each comprising an integrated circuit chip or a wiring substrate, the third device located overlying the second device, the second device overlying the first device, a bottom major surface of the second device having integrated circuitry thereat and at least a third wiring pad; and,
(c) a wirebond directly electrically connecting the third wiring pad with the first wiring pad.

2. The assembly of claim 1 or 8, in which the top major surface of the third device and the bottom major surface of the second device have substantially identical lateral dimensions.

3. The assembly of claim 1 or 2, further comprising an adhesive bonding layer that bonds a bottom major surface of the third device with a top major surface of the second device.

4. The assembly of claim 1 or 3, further comprising a first solder bump directly connecting the second wiring pad with a third wiring pad located on the top surface of the first device.

5. The assembly of claim 4 further comprising a fourth and fifth devices each of which comprises an integrated circuit chip or wiring substrate, the fifth device overlying the fourth device, the fourth device overlying the third device, the fourth device having at least a fourth wiring pad located at a bottom major surface thereof, the fifth device having at least a fifth wiring pad located at a top major surface thereof,
(a) a second wirebond directly connecting the fifth wiring pad with a sixth wiring pad located on the top surface of the first device.

6. The assembly of claim 1 further comprising fourth and fifth devices each of which comprises an integrated circuit chip or a wiring substrate, the fifth device overlying the fourth device, the fourth device overlying the third device, the fourth device having at least a fourth wiring pad located at a top major surface thereof,
(a) a second wirebond directly connecting the fifth wiring pad with a sixth wiring pad located on the top surface of the first device.

7. The assembly of claim 6 further comprising;
(a) a first solder bump directly connecting the second wiring pad with a third wiring pad located on the top surface of the first device and a second solder bump directly connecting the fourth wiring pad with a seventh wiring pad located on the top surface of the third device.

8. The assembly of claim 7 further comprising an adhesive bonding layer that bonds a bottom major surface of the fifth device with a top major surface of the fourth device.

9. The assembly of claim 8 further comprising a second solder bump directly connecting the fourth wiring pad with a seventh wiring pad located on the top surface of the third device.

10. The assembly of claim 7 further comprising a third wirebond directly connecting an eighth wiring pad located on the top surface of the fifth device with a ninth wiring pad located on the top surface of the third device.

11. The assembly of claim 8 further comprising second adhesive bonding layer that bonds a bottom major surface of the fifth device with a top major surface of the fourth device.

12. The assembly of claim 7 in which the top major surface of the fourth device and the bottom major surface of the fifth device have substantially identical lateral dimensions.
